Europäisches Patentamt

European Patent Office

Office européen des brevets

(19)

(11) EP 0 965 848 A1

(12) **EUROPÄISCHE PATENTANMELDUNG**

(43) Veröffentlichungstag:
22.12.1999 Patentblatt 1999/51

(51) Int. Cl.⁶: **G01R 11/24**

(21) Anmeldenummer: 98109397.4

(22) Anmeldetag: 23.05.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(71) Anmelder:
Electrowatt Technology Innovation AG
6301 Zug (CH)

(72) Erfinder:
• Megnet, Rolf
  6414 Oberarth (CH)
• Sabadia, Yusuf
  6030 Ebikon (CH)

(54) **Anordnung zum Erkennen eines Oeffnens und/oder Schliessens eines Gehäuses eines Gerätes zum Messen, Verrechnen und/oder Verbrauchsbeeinflussen eines Verbrauchgutes**

(57) Die Anordnung ist mit einer durch das Öffnen beziehungsweise Schliessen des Gehäuses betätigte Vorrichtung (19) versehen, die ein Bauteil aufweist zur Ermittlung einer durch das Öffnen beziehungsweise Schliessen des Gehäuses verursachten Wertänderung mindestens eines Parameters des Bauteils. Das Bauteil ist vorzugsweise ein mit Zähnen (25, 26, 29, 30) versehenes, nur in einer Richtung drehbares Rad (21), dessen Winkelposition der Parameter ist und welches vorzugsweise als sechszehnstelliger hexadezimalcodierter Drehschalter arbeitet. Die Anordnung gestattet die Häufigkeit des Öffnens und/oder Schliessens des Gehäuses und damit die Anzahl von Betrugsversuchen zu ermitteln.

Fig. 1

Printed by Xerox (UK) Business Services
2.16.7/3.6

EP 0 965 848 A1

**Beschreibung**

Die Erfindung bezieht sich auf eine Anordnung zum Erkennen eines Öffnens und/oder Schliessens eines Gehäuses eines Gerätes zum Messen, Verrechnen und/oder Verbrauchsbeeinflussen eines Verbrauchgutes gemäss dem Oberbegriff des Anspruchs 1.

Das Verbrauchgut ist Elektrizität, Wärme, Gas und/oder Wasser. Das Gerät zum Messen und/oder Verrechnen des Verbrauchgutes ist vorzugsweise ein Elektrizitätszähler, ein dazugehöriges Tarifgerät, ein Wärmezähler, ein Gasmeter, ein Wassermeter und/oder eine Kombination dieser Geräte. Das Gerät zum Verbrauchbeeinflussen ist z. B. ein Rundsteuerempfänger. In diesen Geräten dient die erfindungsgemässe Anordnung zur Feststellung, ob das Gehäuse des Gerätes nach der Inbetriebsetzung noch geöffnet wurde, und wenn ja, wie oft dies der Fall war. Daraus können Schlussfolgerungen gezogen werden, ob Unbefugte das Gehäuse geöffnet haben und ob möglicherweise ein Betrugsversuch vorliegt. Die Anordnung kann also zur Diebstahl-Erkennung verwendet werden.

Eine Anordnung der eingangs genannten Art ist aus der GB 2 230 629 A bekannt, in der ein Ferrari-Elektrizitätszähler beschrieben ist der einen Diebstahlschutz-Schalter aufweist, der bei einem Öffnen des Gehäuses betätigt wird und dessen Information mittels eines sogenannten "Pull up"-Widerstandes erkannt und einem Mikrocomputer zugeführt wird, wo die Information in einem unverlierbaren Speicher gespeichert wird zwecks Weiterverwendung.

Der Erfindung liegt die Aufgabe zugrunde, eine einfache, kostengünstige und raumsparende Anordnung der eingangs genannten Art zu verwirklichen, die es auch gestattet die Häufigkeit des Öffnens und/oder Schliessens des Gehäuses und damit die Anzahl der Betrugsversuche zu ermitteln und zwar vorzugsweise auch bei abwesender oder zu niedriger elektrischer Speisespannung.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ein Ausführungsbeispiel der Erfindung ist in der Zeichnung dargestellt und wird im folgenden näher beschrieben.

Es zeigen:

Fig. 1     einen mechanischen Aufbau einer in der Anordnung enthaltenen erfindungsgemässen Vorrichtung und
Fig. 2     ein Schaltbild einer in der Anordnung enthaltenen elektrischen Schaltung.

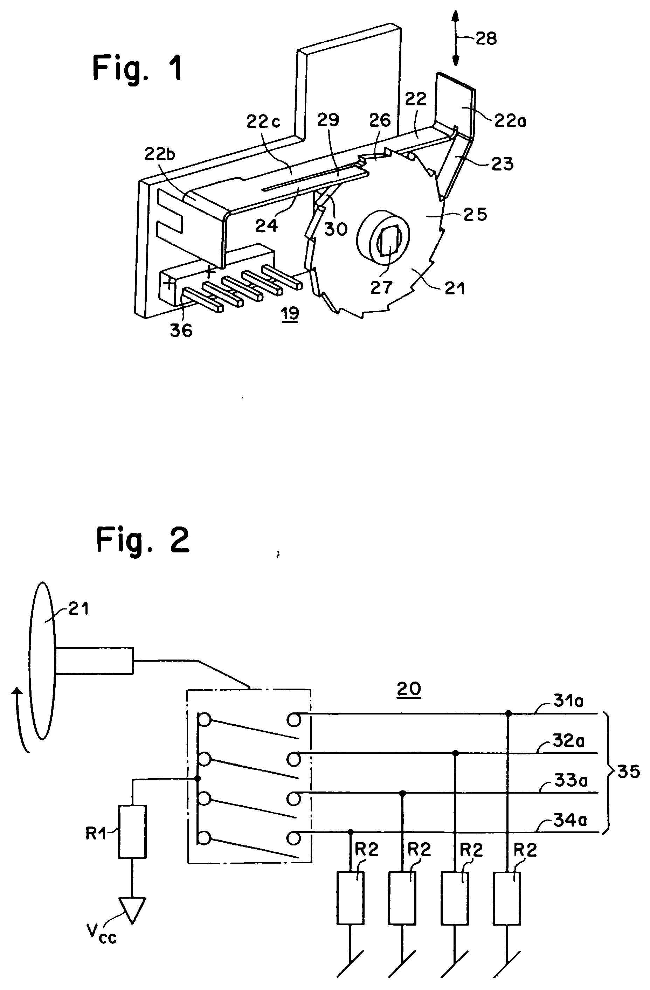

Die Anordnung wird, wie bereits erwähnt, in einem Gerät zum Messen und/oder Verrechnen und/oder Verbrauchsbeeinflussen eines Verbrauchgutes, wie z. B. elektrische Energie, Wärme, Gas und/oder Wasser, verwendet. In der erfindungsgemässen Anordnung zum Erkennen eines Öffnens und/oder Schliessens eines Gehäuses des Gerätes ist eine durch das Öffnen bzw. Schliessen des Gehäuses betätigte Vorrichtung 19 vorhanden, wobei die letztere vorzugsweise durch ein Öffnen und/oder Schliessen eines Deckels des Gehäuses betätigbar ist. Die Vorrichtung 19 weist ein Bauteil auf zur Ermittlung einer durch ein Öffnen und/oder Schliessen des Gehäuses verursachten Wertänderung mindestens eines, eine Vielzahl von analogen oder digitalen Werten aufweisenden Parameters des Bauteils. Das Bauteil ist so ausgebildet, dass das Öffnen bzw. Schliessen des Gehäuses vorzugsweise auch bei einer abwesenden oder zu niedrigen elektrischen Speisespannung ermittelbar ist, bei der eine vorhandene elektrische Schaltung 20 nicht oder noch nicht funktionsfähig ist. Der Parameter ist vorzugsweise eine Position des Bauteils. Das letztere besitzt bevorzugt mehrere diskrete Positionen und rastet dann jeweils nach einem Öffnen und/oder Schliessen des Gehäuses in einer der diskreten Positionen ein. Der Wert bzw. die Wertänderung des Parameters ist dann ein numerischer, digitaler Wert, z. B. ein Zählwert. Das Bauteil ist vorzugsweise ein durch das Öffnen und/oder Schliessen des Gehäuses nur in einer Richtung drehbares Rad (siehe Fig. 1). In diesem Fall ist die Position des Bauteils eine Winkelposition des Rades. Der Parameter besitzt vorzugsweise diskrete Werte und/oder diskrete Wertänderungen. Die Anordnung enthält bevorzugt eine elektrische Schaltung 20 (siehe Fig. 2) zur Ermittlung der Wertänderungen des Parameters. Die elektrische Schaltung 20 enthält ihrerseits einen Mikrocomputer oder sie ist - was in der Zeichnung angenommen wurde - mit einem Mikrocomputer verbunden. Der letztere dient zum Lesen und Speichern der diskreten Werte und/oder der diskreten Wertänderungen des Parameters. Wenn das Bauteil so ausgebildet ist, dass das Öffnen bzw. Schliessen des Gehäuses auch bei einer abwesenden oder zu niedrigen elektrischen Speisespannung ermittelt wird, erfolgt eine Auswertung der ermittelten Werte in der Regel erst später durch die elektrische Schaltung 20, wenn die elektrische Speisespannung wieder vorhanden ist bzw. wieder so gross ist, dass die elektrische Schaltung 20 wieder voll funktionsfähig ist.

In der in der Fig. 1 dargestellte Ausführung der Erfindung ist das Bauteil ein mit Zähnen versehenes Rad 21. Das Rad 21 ist dabei so angeordnet und ausgebildet, dass es nach einem Öffnen und/oder Schliessen des nicht dargestellten Gehäuses mit Hilfe mindestens eines seiner Zähne einrastet. In der Vorrichtung 19 ist zu diesem Zweck vorzugsweise eine Blaufeder 22 vorhanden, die so angeordnet und ausgebildet ist, dass nach einem Öffnen und/oder Schliessen des Gehäuses mindestens ein Blatt der Blattfeder 22 in einem Zahn des Rades 21 einrastet. Die Blattfeder 22 besitzt vorzugsweise zwei Blätter 23 und 24. Ein erstes, in einem ersten Zahn 25 des Rades 21 eingreifendes Blatt 23 dient zur Betätigung des Rades 21 in seiner erlaubten Drehrichtung bei einem Öffnen und/oder Schliessen des Gehäuses. Ein zweites, in einem zweiten Zahn 26 des Rades 21 eingreifendes Blatt 24 dient zur Verhinderung eines Rücklaufs des Rades 21. In der Darstellung der Fig. 1 dreht das mit Zähnen versehene Rad 21 um eine horizontale Rotationsachse 27, während ein erstes Ende 22a der Blattfeder 22 durch das Öffnen und/oder Schliessen des Gehäuses vertikal, quer zur Rotationsachse 27 bewegt wird, was in der Fig. 1 symbolisch durch einen Doppelpfeil 28 dargestellt ist. Die Blattfeder 22 ist an ihrem anderen, zweiten Ende 22b befestigt, welches als Biegedrehachse der Blattfeder 22 dient. Ein die beiden Enden 22a und 22b verbindender Hauptteil 22c der Blattfeder 22 ist horizontal, quer zur Rotationsachse 27 des Rades 21 angeordnet und als Hebel wirksam. Die Biegedrehachse 22a der Blattfeder 22 und die Rotationsachse des Rades 21 sind parallel zueinander angeordnet. Das erste Blatt 23 und das zweite Blau 24 der Blattfeder 22 sind z. B. durch Schlitze vom Hauptteil 22c getrennt und - gebogen oder ungebogen - so angeordnet, dass sie in getrennte Zähnen 25 bzw. 26 des Rades 21 eingreifen. Die Zähnen des Rades 21 besitzen eine unsymmetrische, sägezahnförmige Gestalt, mit einer scharfkantigen Vorderseite und einer abgeflachten Rückseite. Das erste Blau 23 der Blaufeder 22 ist so angeordnet und ausgebildet, dass es bei einer senkrechten Bewegung des ersten Endes 22a der Blattfeder 22 senkrecht tangential zum Rad 21 auf die scharkkantige Vorderseite des ersten Zahns 25 einen Druck ausübt, so dass das Rad 21 sich um eine diskrete Winkelposition in der erlaubten Drehrichtung, d. h. z. B. in Uhrzeigerrichtung dreht. Das zweite Blatt 24 der Blattfeder 22 ist so angeordnet und ausgebildet, dass es in Ruhestellung auf die abgeflachte Rückseite eines dem zweiten Zahn 26 in Drehrichtung vorangehenden Zahns 29 aufliegt und bei einer senkrechten Bewegung des ersten Endes 22a der Blattfeder 22 horizontal tangential zum Rad 21 auf die abgeflachte Rückseite des Zahns 29 gleitet, bis dass es am Ende der zugehörigen diskreten Drehung der Winkelposition die Zahnspitze des Zahns 29 überschreitet und auf die abgeflachte Rückseite eines nächsten Zahns 30 zu liegen kommt, wobei die scharfkantige Vorderseite des Zahns 29 eine unerlaubte Rückwärtsdrehung des Rades 21 verhindert, da die Vorderseite in ihrer Rückwärtsbewegung durch die Vorderkante des zweiten Blattes 24 gehindert wird.

Das Rad 21 besitzt vorzugsweise soviele diskrete Winkelpositionen, wie es Anzahl Zähne aufweist, z. B. sechszehn Stück. Die Winkelpositionen sind dann z. B. fortlaufend von Null bis Fünfzehn durchnumeriert. Die fortlaufenden Nummern sind z. B. hexadezimal codiert und benötigen in diesem Fall zur Darstellung der sechszehn Nummern vier Bits, deren Wertigkeit aus der nachfolgenden Tabelle ersichtlich ist.

| Winkelpositions-Nummer | Bit 4 | Bit 3 | Bit 2 | Bit 1 |
|---|---|---|---|---|
| 0 | "0" | "0" | "0" | "0" |
| 1 | "0" | "0" | "0" | "1" |
| 2 | "0" | "0" | "1" | "0" |
| 3 | "0" | "0" | "1" | "1" |
| 4 | "0" | "1" | "0" | "0" |
| 5 | "0" | "1" | "0" | "1" |
| 6 | "0" | "1" | "1" | "0" |
| 7 | "0" | "1" | "1" | "1" |
| 8 | "1" | "0" | "0" | "0" |
| 9 | "1" | "0" | "0" | "1" |
| 10 | "1" | "0" | "1" | "0" |
| 11 | "1" | "0" | "1" | "1" |
| 12 | "1" | "1" | "0" | "0" |
| 13 | "1" | "1" | "0" | "1" |
| 14 | "1" | "1" | "1" | "0" |
| 15 | "1" | "1" | "1" | "1" |

Jedem Bit ist in der Vorrichtung 19 ein Schalter 31, 32, 33 oder 34 zugeordnet (siehe Fig. 2), dessen Zustand einem Logikwert "1" oder "0" entspricht. Z. B. entspricht ein geschlossener Zustand des Schalters einem Logikwert "1" und ein offener Zustand einem Logikwert "0". Die vier Schalter 31 bis 34 werden bei einer Raddrehung durch das Rad 21 mittelbar oder unmittelbar betätigt, so dass ihr Zustand jeweils der hexadezimal-codierten Nummer der betreffenden Winkelposition entspricht, welche das Rad 21 gerade einnimmt. Das Rad 21 und die Schalter 31 bis 34 bilden zusammen ein sechszehnstelliger hexadezimal-codierter Drebschalter. Die Wirkung des Rades 21 auf die vier Schalter 31 bis 34 ist in der Fig. 2 symbolisch dargestellt. Dort ist auch ersichtlich, dass ein erster Pol der vier Schalter 31 bis 34 über einen gemeinsamen Widerstand R1 mit einem z.B. positiven Pol $V_{CC}$ einer auf Masse bezogenen Speise-Gleichspannung verbunden ist, während ein zweiter Pol der Schalter 31 bis 34 einerseits über je einen getrennten, sogenannten "pull up"-Widerstand R2 mit Masse verbunden ist und anderseits je einen getrennten Bitausgang 31a, 32a, 33a bzw. 34a eines 4 Bit-Ausgangs 35 bildet, der zum parallelen Lesen über eine 4 Bit-Busverbindung mit dem nicht dargestellten Mikrocomputer verbunden ist. Es gilt z. B. R2 = 50 · R1 . Der Pol $V_{CC}$ der Speise-Gleichspannung und die vier Bitausgänge sind z. B. über einen Stecker 36 (siehe Fig. 1) mit den Schaltern 31 bis 34 verbunden. Die Software des Mikrocomputers registriert jede Bit-Änderung, d. h. jede Positionsänderung der Schalter 31 bis 34.

## Patentansprüche

1. Anordnung zum Erkennen eines Öffnens und/oder Schliessens eines Gehäuses eines Gerätes zum Messen, Verrechnen und/oder Verbrauchsbeeinflussen eines Verbrauchgutes, mit einer durch das Öffnen beziehungsweise Schliessen des Gehäuses betätigte Vorrichtung (19), dadurch gekennzeichnet, dass die Vorrichtung (19) ein Bauteil aufweist zur Ermittlung einer durch das Öffnen beziehungsweise Schliessen des Gehäuses verursachten Wertänderung mindestens eines Parameters des Bauteils.

2. Anordnung nach Anspruch 1, dadurch gekennzeichnet, dass der Parameter eine Vielzahl von analogen oder digitalen Werten aufweist.

3. Anordnung nach Anspruch 1 oder 2, dadurch gekennzeichnet, dass sie eine elektrische Schaltung (20) enthält zur Ermittlung der numerischen Wertänderung des Parameters.

4. Anordnung nach einem der Ansprüche 1 bis 3, dadurch gekennzeichnet, dass der Parameter diskrete Werte und/oder diskrete Wertänderungen besitzt.

5. Anordnung nach Anspruch 4, dadurch gekennzeichnet, dass die elektrische Schaltung (20) einen Mikrocomputer enthält oder mit einem Mikrocomputer verbunden ist zum Lesen und Speichern der diskreten Werte und/oder diskreten Wertänderungen des Parameters.

6. Anordnung nach einem der Ansprüche 1 bis 5, dadurch gekennzeichnet, dass das Bauteil so ausgebildet ist, dass das Öffnen beziehungsweise Schliessen des Gehäuses auch bei einer abwesenden oder zu niedrigen elektrischen Speisespannung ermittelbar ist, bei der eine vorhandene elektrische Schaltung (20) nicht funktionsfähig ist.

7. Anordnung nach einem der Ansprüche 1 bis 6, dadurch gekennzeichnet, dass der Parameter eine Position des Bauteils der Vorrichtung (19) ist.

8. Anordnung nach Anspruch 7, dadurch gekennzeichnet, dass das Bauteil ein durch das Öffnen und/oder Schliessen des Gehäuses nur in einer Richtung drehbares Rad (21) ist und die Position des Bauteils eine Winkelposition des Rades (21) ist.

9. Anordnung nach Anspruch 8, dadurch gekennzeichnet, dass das Rad (21) mit Zähnen (25, 26, 29, 30) versehen ist.

10. Anordnung nach einem der Ansprüche 7 bis 9, dadurch gekennzeichnet, dass das Bauteil mehrere diskrete Positionen besitzt und das Bauteil jeweils nach einem Öffnen und/oder Schliessen des Gehäuses in einer der diskreten Positionen einrastet.

11. Anordnung nach Anspruch 10, dadurch gekennzeichnet, dass das Bauteil ein mit Zähnen (25, 26, 29, 30) versehenes Rad (21) ist, welches so angeordnet ist, dass nach einem Öffnen und/oder Schliessen des Gehäuses das Rad (21) mit Hilfe eines seiner Zähne einrastet.

12. Anordnung nach Anspruch 11, dadurch gekennzeichnet, dass in der Vorrichtung (19) eine Blattfeder (22) vorhanden, die so angeordnet und ausgebildet ist, dass nach einem Öffnen und/oder Schliessen des Gehäuses mindestens ein Blatt (23) der Blattfeder (22) in einem Zahn (25) des Rades (21) einrastet.

13. Anordnung nach Anspruch 12, dadurch gekennzeichnet, dass die Blattfeder (22) ein erstes, in einem ersten Zahn (25) des Rades (21) eingreifendes Blatt (23) besitzt zur Betätigung des Rades (21) in seiner erlaubten Drehrichtung bei einem Öffnen oder Schliessen des Gehäuses und die Blattfeder (22) ein zweites, in einem zweiten Zahn (26) des Rades (21) eingreifendes Blau (24) besitzt zur Verhinderung eines Rücklaufs des Rades (21).

14. Anordnung nach einem der Ansprüche 8 bis 13, dadurch gekennzeichnet, dass Schalter (31 bis 34) vorhanden sind, die bei einer Raddrehung durch das Rad (21) mittelbar oder unmittelbar betätigt werden und deren Zustand jeweils einem Logikwert "1" oder "0" entspricht.

15. Anordnung nach Anspruch 14, dadurch gekennzeichnet, dass das Rad (21) und die Schalter (31 bis 34) zusammen einen Drehschalter bilden.

16. Anordnung nach Anspruch 15, dadurch gekennzeichnet, dass der Drehschalter ein sechszehnstelliger hexadezimal-codierter Drehschalter ist.

# Fig. 1

# Fig. 2

Europäisches
Patentamt

# EUROPÄISCHER RECHERCHENBERICHT

Nummer der Anmeldung

EP 98 10 9397

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | EP 0 447 615 A (LANDIS & GYR) 25. September 1991 | 1-4,6,7 | G01R11/24 |
| Y | * Spalte 4, Zeile 6 - Spalte 5, Zeile 52; Abbildungen 3,4 * | 8-11 | |
| X | EP 0 549 519 A (FR. SAUTER AG) 30. Juni 1993 * Zusammenfassung * * Spalte 5, Zeile 52 - Zeile 56; Abbildungen 1,2 * | 1-6 | |
| Y | EP 0 141 701 A (SANGAMO WESTON) 15. Mai 1985 | 8-11 | |
| A | * Seite 2, Zeile 7 - Seite 3, Zeile 7 * * Seite 6, Zeile 19 - Seite 7, Zeile 14; Abbildung 2 * | 12,13 | |
| X | EP 0 490 710 A (SCHLUMBERGER) 17. Juni 1992 * Zusammenfassung * | 1,3,4,6 | |
| A | GB 2 286 303 A (FORD MOTOR CO) 9. August 1995 | 7,8,10, 14-16 | **RECHERCHIERTE SACHGEBIETE** (Int.Cl.6)<br><br>G01R<br>G01D |

Der vorliegende Recherchenbericht wurde für alle Patentansprüche erstellt

| Recherchenort | Abschlußdatum der Recherche | Prüfer |
|---|---|---|
| DEN HAAG | 23. Oktober 1998 | Iwansson, K |

## ANHANG ZUM EUROPÄISCHEN RECHERCHENBERICHT
## ÜBER DIE EUROPÄISCHE PATENTANMELDUNG NR.

EP 98 10 9397

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-10-1998

| Im Recherchenbericht angeführtes Patentdokument | | Datum der Veröffentlichung | Mitglied(er) der Patentfamilie | | Datum der Veröffentlichung |
|---|---|---|---|---|---|
| EP 447615 | A | 25-09-1991 | DE | 59008437 D | 23-03-1995 |
| EP 549519 | A | 30-06-1993 | CH | 683569 A | 31-03-1994 |
| | | | DE | 59205961 D | 15-05-1996 |
| | | | ES | 2084978 T | 16-05-1996 |
| EP 141701 | A | 15-05-1985 | US | 4588949 A | 13-05-1986 |
| | | | CA | 1224551 A | 21-07-1987 |
| | | | JP | 60155923 A | 16-08-1985 |
| EP 490710 | A | 17-06-1992 | FR | 2670285 A | 12-06-1992 |
| | | | AT | 119996 T | 15-04-1995 |
| | | | DE | 69108201 D | 20-04-1995 |
| | | | DE | 69108201 T | 20-07-1995 |
| | | | DK | 490710 T | 24-07-1995 |
| | | | ES | 2069245 T | 01-05-1995 |
| | | | GR | 3015575 T | 30-06-1995 |
| GB 2286303 | A | 09-08-1995 | DE | 19500617 A | 10-08-1995 |
| | | | JP | 7294287 A | 10-11-1995 |

EPO FORM P0461

Für nähere Einzelheiten zu diesem Anhang : siehe Amtsblatt des Europäischen Patentamts, Nr.12/82